Europäisches Patentamt

European Patent Office

Office européen des brevets

(11) Veröffentlichungsnummer: **0 042 961**

**B1**

(12) **EUROPÄISCHE PATENTSCHRIFT**

(45) Veröffentlichungstag der Patentschrift: **18.09.85**

(51) Int. Cl.⁴: **H 03 K 3/78, G 11 C 29/00**

(21) Anmeldenummer: **81103733.2**

(22) Anmeldetag: **15.05.81**

(54) **Verfahren und Anordnung zur Erzeugung von Impulsen vorgegebener Zeitrelation innerhalb vorgegebener Impulsintervalle mit hoher zeitlicher Auflösung.**

(30) Priorität: **25.06.80 DE 3023699**

(43) Veröffentlichungstag der Anmeldung:
**06.01.82 Patentblatt 82/01**

(45) Bekanntmachung des Hinweises auf die
Patenterteilung:
**18.09.85 Patentblatt 85/38**

(84) Benannte Vertragsstaaten:
**DE FR GB**

(56) Entgegenhaltungen:
**DE-A-2 746 743**
**DE-A-2 829 709**
**DE-A-2 917 017**

(73) Patentinhaber: **IBM DEUTSCHLAND GMBH**
**Pascalstrasse 100**
**D-7000 Stuttgart 80 (DE)**
(84) **DE**

(73) Patentinhaber: **International Business Machines**
**Corporation**
**Old Orchard Road**
**Armonk, N.Y. 10504 (US)**
(84) **FR GB**

(72) Erfinder: **Staiger, Dieter**
**Im Furtbrunnen 17**
**D-7031 Weil im Schönbuch (DE)**

(74) Vertreter: **Blutke, Klaus, Dipl.-Ing.**
**Schönaicher Strasse 220**
**D-7030 Böblingen (DE)**

Courier Press, Leamington Spa, England.

## Beschreibung

Die Erfindung betrifft ein Verfahren zur Erzeugung zeitlich unmittelbar aufeinanderfolgender Impulsfolgen.

Des weiteren betrifft die Erfindung eine Anordnung zur Durchführung eines solchen Verfahrens.

Derartige Impulsfolgen sind insbesondere zum Austesten von Speicherprodukten (Speicher mit zugehörigen Pufferspeichern) u.a. mit erforderlich.

Bisher waren der zeitlichen Auflösung eines solchen Verfahren bzw. einer Anordnung zur Durchführung eines solchen Verfahrens durch die verfügbare Schaltkreistechnologie und der damit verbundenen Schnelligkeit der Schaltkreise Grenzen gesetzt.

Beim Austesten von Speicherprodukten wird diesen ein entsprechendes Impulsmuster zugeführt. Das Verhalten des Speicherproduktes hinsichtlich dieses Impulsmusters wird aufgezeichnet und mit theoretischen Wunschwerten verglichen. Der Vergleich beider Werte ermöglicht eine Aussage, ob das Speicherprodukt wie gewünscht arbeitet oder ob an bestimmten Stellen Fehler vorliegen.

Die zu erzeugende Impulsfolge ist zunächst theoretisch durch die Spezifikationen des Speicherproduktes vorgegeben.

Ausgehend von diesen theoretischen Werten muß es praktisch von einem Impulsgenerator erzeugt werden.

Bisher wurde ein Speicherprodukt mit einer eigens für dieses Produkt geschaffenen Hardware-Testeinrichtung geprüft. Solche Hardware-Testeinrichtungen sind jedoch mit dem Nachteil behaftet, daß sie nur für ein spezielles Speicherprodukt verwendet werden könne. Weiterhin sind solche Hardware-Testeinrichtungen mit dem Nachteil behaftet, daß sogenannte Wartezeiten in Kauf genommen werden müssen. In diesen Wartezeiten können sich bestimmte Veränderungen im auszutestenden Produkt einstellen. Unter solchen Veränderungen kann das Ent- oder Umladen von Kapazitäten verstanden werden und anderes mehr.

Zur näheren Erklärung sei bemerkt, daß für ein möglichst optimales Austesten auch der Fall zu berücksichtigen ist, daß bei einem von der Produktseite her bestimmten Ereignis eine Impulsfolge von einer anderen abgelöst werden muß. D. h., die ursprüngliche Impulsfolge ist durch eine neue Impulsfolge beim Auftreten eines solchen Ereignisses zu ersetzen. Das Umschalten von einer Impulsfolge auf eine andere erforderte bei herkömmlichen Hardware-Testeinrichtungen eine bestimmte Zeit. Ein nahtloses Umschalten war aus technischen Gründen nicht möglich, da das Umschalten auf eine neue Impulsfolge erst zu einer Zeit erfolgen kann, wenn immer auftretende Umschalt-Einschwingvorgänge abgeklungen sind. Durch die Inkaufnahme einer dadurch bedingten Wartezeit mußte jedoch der Nachteil in Kauf genommen werden, daß sich während dieser Wartezeit andere Konditionen im auszutestenden Produkt einstellen konnten.

Seitens der Anmelderin wurde in der deutschen Offenlegungsschrift 27 46 743 (GE 977 024) ein Verfahren und eine Anordnung zur Erzeugung zeitlich unmittelbar aufeinanderfolgender Impulsfolgen vorgeschllagen, welches dadurch gekennzeichnet war, daß von einem zähltaktgetriebenen von einem Speicher mit einem Ausgangszählwert ladbaren Abwärtszähler bei Erreichung eines bestimmten Zählerstandes die Impulserzeugung abgeleitet wird, daß vor Erreichung dieses bestimten Zählerstandes das Laden des Abwärtszählers mit einem neuen Zählerausgangswert aus dem Speicher eingeleitet und zu einem Zeitpunkt vollzogen wird, an dem der Abwärtszähler für den vorausgehenden Zählvorgang den Zählerstand null erreicht hätte, so daß die Abwärtszählvorgänge zeitlich unmittelbar aufeinanderfolgen und somit auch der zeitliche Abstand der von den Abwärtszählvorgängen abgeleiteten Impulsen von den durch den Speicher zur Verfügung zu stellenden Zählerausgangswerten gesteuert wird. Unter Zugrundelegung eines eine Anordnung zur Durchführung dieses Verfahrens triebenden 100-MHz-Oszillators (eine höhere Frequenz des Oszillators ließe die Schnelligkeit der verfügbaren Schaltkreise nicht zu) ließen sich Impulse vorgegebener Zeitrelation (mit einem 1-Nanosekunden-Zeitraster) innerhalb vorgegebener Impulsintervalle mit einem 10-Nanosekunden-Zeitraster erzeugen. Eine derartige 10-Nanosekunden-Zeitrasterung war jedoch insbesondere für das Austesten sehr schneller Speicherprodukte unzureichend.

Aus diesem Grunde wurde von der Ammelderin in einer weiteren Patentanmeldung OS 28 29 709 (GE 978 014) ein Verfahren zur Erzeugung zeitlich unmittelbar aufeinanderfolgender Impulszyklen vorgeschlagen, bei dem von einem zähltaktgetriebenen und von einem Speicher mit einem Ausgangszählwert ladbaren Abwärtszähler bei Erreichung eines bstimmten Zählerstandes die Erzeugung des Impulszyklus abgeleitet wird und bei dem vor Erreichung dieses bestimmten Zählerstandes das Laden des Abwärtszählers mit einem neuen Zählerausgangswert aus dem Speicher eingeleitet und zu einem Zeitpunkt vollzogen wird, an dem der Abwärtszähler für den vorausgehenden Zählvorgang den Zählerstand Null erreicht hätte. Dieses Verfahren war dadurch gekennzeichnet, daß der Beginn eines Abwärtszählvorganges des Abwärtszählers um ganzzahlige Vielfache des Zähltaktes verzögert wird, und daß ein bei Erreichung eines bestimmten Zählerstandes des Abwärtszählers abgeleiteter Impuls I einer zeitlichen Verzögerung hoher Auflösung zur Vorgabe eines Zyklusbeginnimpulses unterworfen wird.

Die in dieser Offenlegungsschrift OS 28 29 709 beschriebene Anordnung machte es möglich, auch Impulsintervalle im 1-Nanosekunden-Zeitraster vorzusehen. Jedoch mußte (schaltungsbedingt) der Beginn eines neuen Impulsintervalles immer mit dem Beginn eines von einem Quarzoszillator abgeleiteten 10-Nanosekunden-Zeitrasters übereinstimmen. Aus diesem Grunde waren bei dieser Anordnung sogenante "Totzeiten" von ca. 20 ns in Kauf zu nehmen, die sich entweder vor Beginn eines neu zu erzeugenden Pulses oder nach Abklingen eines bereits erzeugten Impulses bis zum Beginn des folgenden Impulsintervalles ergaben.

Der Grund hierfür lag darin, daß die 1-Nanosekunden-Verzögerungswerte für die zu erzeugenden Impulse zur Steuerung der Schaltung in entsprechende Zähler zu laden waren, und daß diese Ladevorgänge nur zu Zeiten durchgeführt werden konnten, während der keine Impulserzeugung ablief bzw. während der ein erzeugter Impuls bereits abgeklungen war.

Somit war es nicht möglich, Impulsintervalle mit einer zeitlichen Auflösung im 1-Nanosekunden-Zeitraster aufeinander folgen zu lassen.

Es ist deshalb Aufgabe der Erfindung, zur Vermeidung der Totzeiten bei der Erzeugung von Impulsen vorgegebener Zeitrelation innerhalb vorgegebener Impulsintervalle ein Verfahren und eine Anordnung zur Durchführung des Verfahrens angegeben, das es möglich macht, Impulsintervalle hoher zeitlicher Auflösung mit Impulsen ebenfalls hoher zeitlicher Auflösung unmittelbar (ohne Totzeit) aufeinander folgen zu lassen.

Diese Aufgabe der Erfindung wird in vorteilhafter Weise durch die im kennzeichnenden Teil der Ansprüche 1 bzw. 8. angegebenen Maßnahmen gelöst.

Vorteilhafte Weiterbildungen der Erfindung sind den Unteransprüchen zu entnehmen.

Prinzipdarstellungen zum Verständnis der Erfindung sowie eine Anordnung zur Durchführung des erfindungsgemäßen Verfahrens sind in den Zeichnungen dargestellt und werden im folgenden näher beschrieben.

Es zeigen:

Fig. 1 ein schematisches Blockschaltbild zur Wirkungsweise der Zweiwegschaltung für eine totzeitlose Erzeugung von Impulsen vorgegebener Zeitrelation mit hoher zeitlicher Auflösung innerhalb vorgegebener Impulsintervalle mit ebenfalls hoher zeitlicher Auflösung,

Fign. 2A und 2B vereinfachte Darstellungen eines Impulsrasters,

Fign. 2C und 2D vereinfachte Darstellungen eines Impulsintervalles mit einem in diesem Intervall auftretenden Impuls,

Figs. 3A eine vereinfachte Darstellung zweier aufeinanderfolgender Impulsintervalle mit jeweils einem darin liegenden Impuls,

Fign. 3B und 3C eine vereinfachte Darstellung zum Prinzip der Impulsbildung in aufeinanderfolgenden Impulsintervallen auf unterschiedlichen Wegen,

Fig 4A bis 4C Zeitdiagramm der die Impulsintervalle nach Anfang und Ende kennzeichnenden, gedachten Impulse, welche für die Schaltung gemäß Fig. 4 auf zwei Wege aufgeteilt werden,

Fig. 5A bis 5E Zeitdiagramm für die Impulszeugung auf zwei Wegen,

Fign. 6A und 6B eine schematische Darstellung zur Tastung von Sendefrequenzen mit einer Impulsfolge, welche mit Hilfe der Schaltung nach Fig. 1 erzeugbar ist.

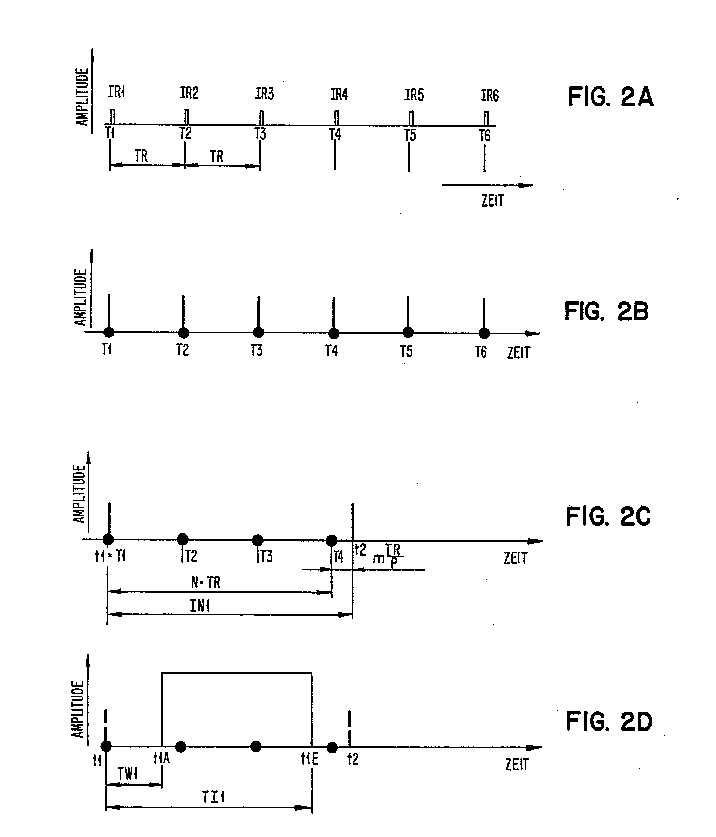

Die Erfindung dient der Erzeugung definierter Impulse innerhalb definierter Impulsintervalle. Die Zeitgebung für die Impulsintervalle ist auf einen quarzgesteuerten Impulsoszillator zurückzuführen. Die Quarzsteuerung garantiert eine präzise Zeitauflösung aufgrund der vom Quarzoszillator gelieferten Impulse. Diese Impulse sind in der Darstellung nach Fig. 2A mit IR1, IR2, IR3, IR4, IR5, IR6 etc. gekennzeichnet. Die einzelnen Impulse weisen voneinander einen Abstand von TR auf; sie treten zu den Zeitpunkten T1, T2, T3, T4, T5 und T6 auf. Unter Zugrundelegung modernster Schaltkreistechnologie kann z.B. angenommen werden, daß ein 100-MHz-Oszillator verwendet wird, dessen Impulse in einem 10-Nanosekundenraster liegen. Auf die Darstellung in Fig. 2A bezogen würde dies bedeuten, daß der Abstand aufeinanderfolgender Impulse, z.B. IR1 und IR2 TR=10 Nanosekunden beträgt. Dieses Beispiel eines solchen Impulszeitrasters liegt den folgenden Betrachtungen zugrunde. Es sei jedoch darauf hingewiesen, daß auch andere Zeitraster Verwendung finden können. Zur einfacheren Darstellung der in Fig. 2A angedeuteten Impuls- und Zeitverhältnisse sie auf Fig. 2B verwiesen. Die einzelnen Impulse sind durch einfache Linien dargestellt, welche zu den Zeitpunkten T1, T2, T3, T4, T5, T6 auftreten. Das Zeitraster ist durch ausgefüllte Kreise gekennzeichnet. Diese Darstellung des Zeitrasters wird auch in nachfolgenden Abbildungen beibehalten.

In Fig. 2C ist ein Impulsintervall IN1 dargestellt, dessen Anfang und Ende durch die gedachten Impulse IIN1A and IIN1E gekennzeichnet ist. Der gedachte Impulse IIN1A soll zum Zeitpunkt t1 auftreten, der mit dem Zeitpunkt T1 gemäß der Darstellung in Fign. 2A und 2B übereinstimmt. Der gedachte Impuls IIN1E tritt zum Zeitpunkt t2 uf. Dieser Zeitpunkt t2 muß nicht mit dem Zeitrasters des Quarzoszillators übereinstimmen. (Wie bei der Würdigung des Standes der Technik im Zusammenhang mit OS 28 29 709 erwähnt, war es möglich, Impulsintervalle im 1-Nanosekunden-Zeitraster zu erzeugen, das weit feiner ist als das 10-Nanosekunden-Zeitraster des Quarzoszillators. Für diese Feinrasterung wurde eine Verzögerungsleitung mit entsprechenden Abgriffen für eine zeitliche Feinverzögerung (im 1-Nanosekundenraster) verwendet).

Die Gesamtzeit des Impulsintervales IN1 setzt sich somit zusammen au einer ganzzahligen Vielfachen des groben Zeitrasters $n \cdot TR$ des Quarzoszillators und einem ganzzahligen Vielfachen der zeitlichen Feinrasterung

$$m \cdot \frac{TR}{10}$$

der Verzögerungsleitung. Würde also die zeitliche Breite des Impulsintervalles IN1 33 Nanosekunden betragen, so entfielen hiervon 3×10 Nanosekunden auf das zeitliche Grobraster des Quarzoszillators und 3×1/10 Nanosekunden=3 Nanosekunden auf das zeitliche Feinraster der Verzögerungsleitung. Aus der Darstellung in Fig. 2D geht hervor, daß in einem durch die Zeitpunkte t1 und t2 liegenden Zeitintervall gemäß Fig. 2C ein Impuls I1 lieft, dessen zeitlicher Beginn durch den Zeitpunkt t1A und dessen zeitliches Ende durch den Zeitpunkt t1E gekennzeichnet ist. Die diese Größen kennzeichnenden Werte, nämlich die Zeit des Impulsbeginnes t1A nach Impulsintervallbeginn t1 und die Impulsdauer des Impulses I1 sind wie die Impulsintervallänge IN1 als Zeitwerte TW1 und TI1 in einem Speicher programmgesteuert verfügbar. Die Erzeugung des Impuls I1 innerhalb eines vorgegebenen Zeitintervalles war mit Hilfe entsprechender Zähler und einer Verzögerungsleitung mit entsprechenden Abgriffen (für die einzelnen zeitlichen Auflösungswerte) möglich, wie es in der bereits erwähnten Anmeldung beschrieben wurde. Impulsbeginn und Impulsende des Impulses I1 konnten außerhalb des Zeitrasters des Quarzoszillators liegen.

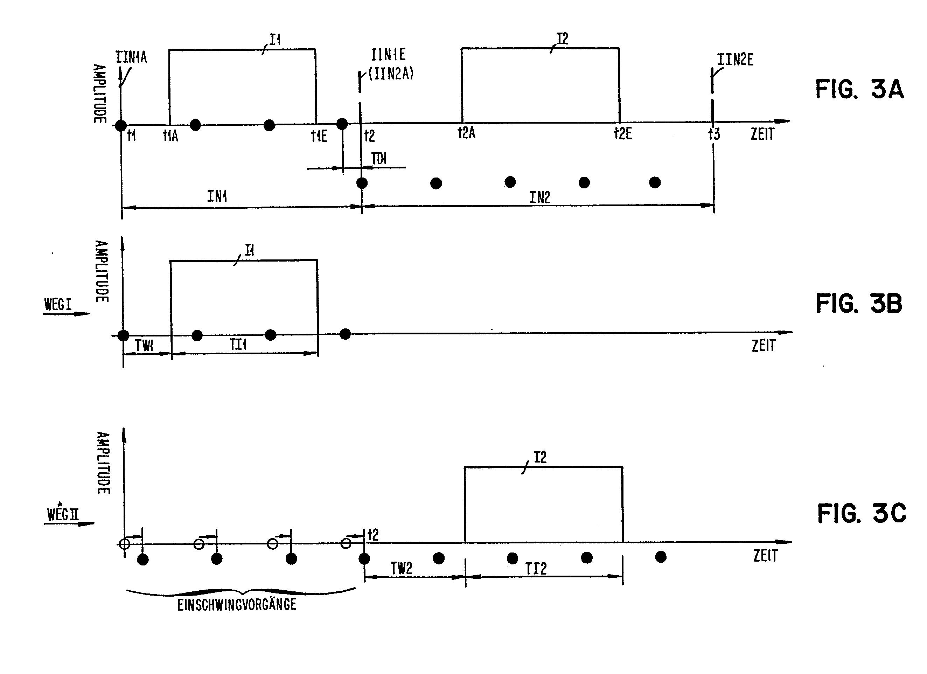

In Fig. 3A sind zwei aufeinanderfolgende Impulsintervalle IN1 und IN2 dargestellt. Das Impulsintervall IN1 beginnt zum Zeitpunkt t1 und endet zum Zeitpunkt t2, das daran anschließende Impulsintervall IN2 beginnt beim Zeitpunkt t2 und endet bei t3. Die Zeitpunkte t1, t2 und t3 sollen durch gedachte Impulse IIN1A, INN1E=IN2A und IIN2E festgelegt sein. In dem Intervall IN1 liegt der Impuls I1 mit einem zeitlichen Beginn bei t1A und einem zeitlichen Ende bei t1E. Der Impuls I2 im Impulsintervall IN2 beginnt bei t2A und endet bei t2E. Die Zeitpunkt t2 and t3 müssen nicht mit dem Zeitraster des Quarzoszillators übereinstimmen. Die Zeitdifferenzen des ersten Impulsintervallendes t2 zum davor liegenden Zeitraster des Quarzoszillators ist mit TD1 gekennzeichnet. Die Erzeugung des Impulses I1 innerhalb des ersten Impulsintervalles IN1 und die des Impulses I2 innerhalb des zweiten Impulsintervalles IN2 erfolgt getrennt auf zwei verschiedenen Wegen. In Fig. 3B ist angegeben, wie der Impuls I1 im Impulsintervall IN1 auf einem Weg I erzeugt wird. Vor Beginn des Intervalles IN1 sollen die diesen Impuls kennzeichnenden Werte wie Impulsbeginn TW1 und Impulsdauer TI1 in einem Speicher programmgesteuert abrufbar sein. Mit Hilfe dieser Werte kann, wie auch im Zusammenhang mit der Anmeldung beschrieben, die Erzeugung des Impulses I1 bewirkt werden. Dazu ist lediglich rechtzeitig ein entsprechender Verzögerungsleitungsabgriff zu aktivieren, so daß nach dem Auftreten des vor dem Beginn des Impulses I1 zum Zeitpunkt t1A liegenden Rasterzeitpunktes des Quarzoszillators des Impuls abgenommen werden kann, dessen Ende zählergesteuert auf t1E festgelegt ist. Die Tatsache, daß die diesen Impuls I1 kennzeichnenden Werte TW1 und TI1 schon vor Impulsintervallbeginn verfügbar sind,

machen es möglich, diesen impuls zu beliebigen Zeiten innerhalb des Intervalls zorzugeben. Im Extremfall kann der Impulsbeginn sogar mit dem Beginn des Impulsintervalls zum Zeitpunkt t1 zusammenfallen und das Impulsende kann sogar über den Zeitpunkt des Impulsintervallsendes t2 hinausreichen. Es ist nicht eforderlich, daß der Impuls schon vor dem Impulsintervallende also vor t2 endet, um Zeit für das Laden von Zählern zu gewinnen, die die Erzeugung des Impulses für das darauffolgende Impulsintervall steuern sollen. Denn für die Erzeugung des Impulses I2 im nachfolgenden Impulsintervall IN2 soll ein anderer Schaltungsweg, der in Fig. 3C mit Weg I1 gekennzeichnet ist, verwendet werden. Auf diese Weise brauchen bei der Erzeugung der Impulse innerhalb der einzelnen Intervalle keine Totzeiten in Kauf genommen zu werden, die sonst erforderlich wären, um ein rechtzeitiges Laden der Steuerzähler zu bewirken.

Für die Erzeugung des Impulses I2 im Impulsintervall IN2 gäbe es theoretisch zwei Möglichkeiten:

1. Es wäre vorstellbar, den Zeitpunkt t2A durch entsprechende zeitliche Verzögerung des das Ende des ersten Impulsintervalles kennzeichnenden Zeitpunktes t2 zu erreichen. In diesem Zusammenhang sei bemerkt, daß t2 mit dem Rastermaß dem Zeitrastermaß des Quarzoszillators übereinstimmen müßte. Für diese Lösung böte sich eine Verzögerungsleitung mit vielen Verzögerungsleitungsabgriffen entsprechender zeitlicher Auflösung an. Diese Lösung wäre jedoch mit dem Nachteil behaftet, daß die erstrebte höchste Präzision der quarzgesteuerten Zeitgabe verlassen wird und man sich mit der ungenaueren Präzision der Verzögerungsleitungsabgiffe begnügt. Dieser Umstand wirkt sich dann nachteilig aus, wenn die Zeit TW2 größer als ein Zeitrastermaß des Quarzoszillators ist.

2. Um jedoch die Zeitgabe bei der Erzeugung des Impulses I2 im wesentlichen auf die quarzgesteuerte Zeitrasterung des Quarzoszillators zurückzuführen, soll bewirkt werden, daß der Beginn t2 des zweiten Zeitintervalles IN2 mit dem Rastermaß der des Quarzoszillators in Übereinstimmung gebracht wird. Dazu ist vor Beginn des zweiten Impulsintervalles IN2 das Zeitraster des Quarzoszillators getrennt vom Weg 1, um die Größe TD1 zu verzögern. Eine solche Verzögerung kann durch eine Verzögerungsleitung mit Abgriffen entsprechender zeitliver Auflösung bewirkt werden. Diese Verzögerungsleitung braucht nur einen maximalen Verzögerungswert aufzuweisen, der unter dem Zeitraster des groben Quarzoszillators liegt (d. h. bei einem 10-Nanosekunden-Zeitraster des Quarzoszillators braucht diese Verzögerung nur insgesamt 9 Abgiffe mit einer zeitlichen Abstaffelung von 1 Nanosekunde aufzuweisen). Das Umschalten des Impulsrasters des Quarzoszillators auf einen anderen Verzögerunsleitungsabgiff ist jedoch mit Einschwingvorgängen verknüpft, die aber spätestens mit Beginn t2 des zweiten Impulsintervalles IN2 abgeklungen sind. Diese Umschaltvorgänge im Weg II treten während der Zeit auf, in der auf Weg I der Impuls I1 bei einem unverschobenen zeitlichen Raster des Impulses des Quarzoszillators gebildet wird. Beide Vorgänge können also nicht störend aufeinander einwirken. Für die Erzeugung des Impulses I2 im zweiten Impulsintervall IN2 gilt analog das gleiche wie bei der Erzeugung des Impulses I1.

Wenn in diesem Zusammenhang von Einschwingvorgängen gesprochen wird, so soll darunter folgendes verstanden werden: Da die Multiplex-Steuerschaltungen kontinuierlich mit der dem 10-Nanosekunden-Zeitraster des 100-MHz-Quarzoszillators beaufschlagt werden, wäre es im üblichen Sinne unkorrekt, von "Einschwingvorgängen" zu sprechen. Solche Einschwingvorgänge treten nämliche nur dann auf, wenn es sich um das Einschalten eines Signales handelt. Da das Zuschalten eines Verzögerungsleitungsabgriffes durch die Multiplex-Steuerschaltung mit der 10-Nanosekunden-Zeitrasterfolge nicht synchronisiert ist, kann der Fall auftreten, daß ein solches Zuschalten gerade während eines 10-Nanosekunden-Rasterpulses erfolgt und diesen "zerstört". D. h., dieser "zerstörte" Impuls ist für spätere Schaltvorgänge unwirksam. Auf diese Weise kann erst der nach dem "zerstörten" Impuls innerhalb der 10-Nanosekunden-Zeitrasterfolge auftretende Impuls für Schaltvorgänge wirksam werden. Die Zeit, die zwischen einem "zerstörten" Impuls und dessen Folgeimpuls auftritt, wird hier in (unüblicher Art) als "Einschwingvorgang" bezeichnet. Im Ergebnis eines solchen "Einschwingens" steht der für Schaltvorgänge maßgebende neue Impuls erst nach einer bestimmten (Einschwing)-Zeit zur Verfügung.

Auf diese Art und Weise werden abwechselnd auf den Wegen I und II die Impulse für aufeinander folgende Impulsintervalle erzeugt. Mit anderen Worten: Erzeugung des Impulses I1 auf Weg I, zeitlich gefolgt von der Erzeugung des Impulses I2 auf Weg II, zeitlich gefolgt von der Erzeugung des Impulses I3 auf Weg I, zeitlich gefolgt von der Erzeugung des Impulses I4 auf Weg II etc. Die auf den getrennten Wegen I und II erzeugten Impulse werden summarisch zusammengeführt, um letztlich die in Fig. 3A dargestellte Impulsfolge zu erhalten.

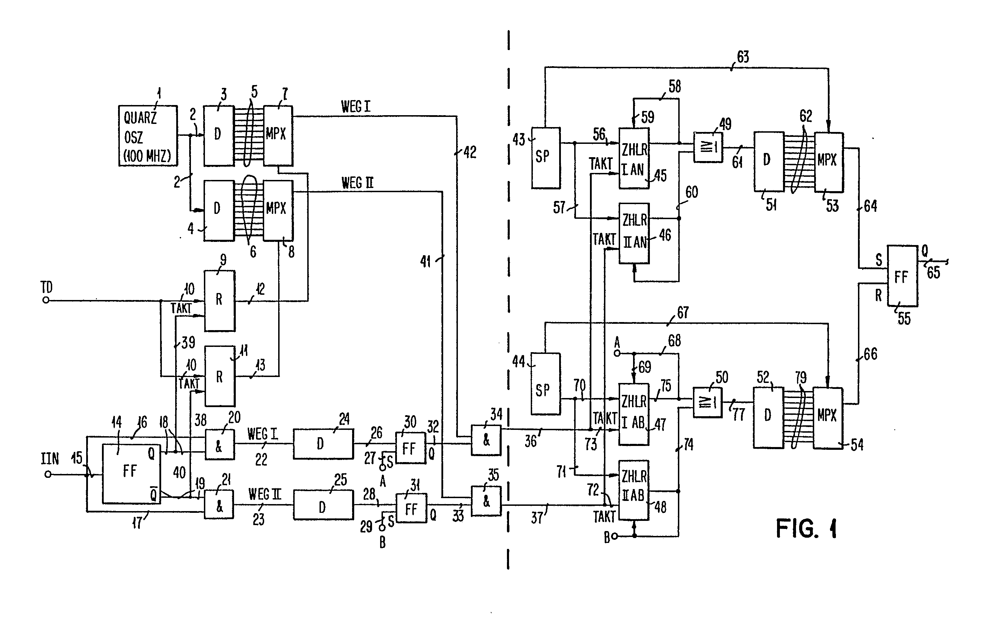

Fig. 1 zeigt eine Anordnung zur Erzeugung von Impulsen vorgegebener Zeitrelation mit hoher zeitlicher Auflösung innerhalb von Impulsintervallen mit ebenfalls hoher zeitlicher Auflösung. Diese Anordnung ist so konzipiert, daß eine totzeitlose Impulserzeugung möglich ist.

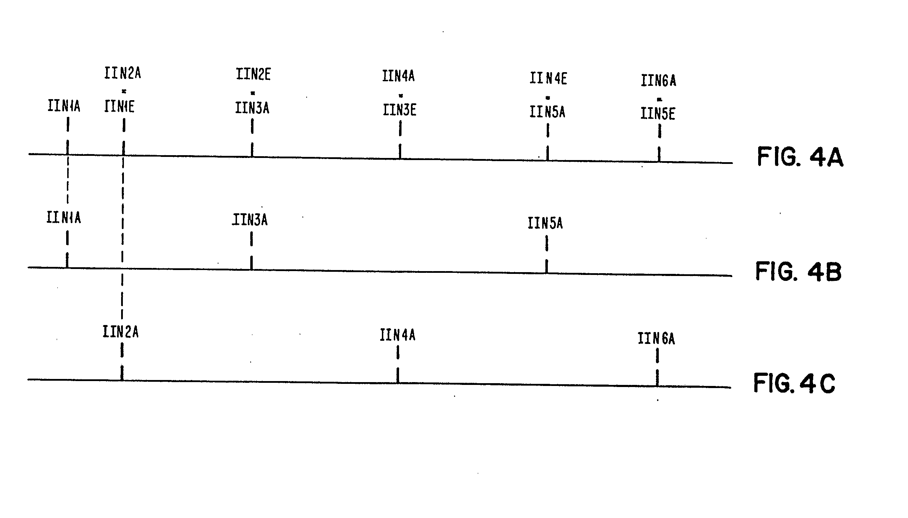

Jedes Impulsintervall ist, wie sich aus der Prinzipdarstellung in Fig. 4A ersehen läßt, durch einen gedachten Impulsintervallanfang und ein gedachtes Impulsintervallende gekennzeichnet. Die Impulsintervalle sollen einander anschließen, so daß das Impulsintervallende eines vorausgehenden Impulsintervalls mit dem Impulsintervallanfang des nachfolgenden Impulsintervalls zusammenfällt. Der Impulsintervallanfang für das erste Impulsintervall ist mit IIN1A, das Impulsintervallende für das erste Impulsintervall mit IIN1E gekennzeichnet. Das an das erste Impulsintervall anschließende zweite Impulsintervall hat einen mit IIN2A=IIN1E gekennzeichneten Impulsintervallbeginn und ein mit IIN2E gekennzeichnetes Impulsintervallende. Analoges gilt für das daran anschließende dritte, vierte und fünfte Impulsintervall etc. Der linke Teil der Schaltung gemäß Fig. 1 hat nun die Aufgabe, die einzelnen Impulsintervalle kennzeichnenden Größen IIN1A, IIN2A=IIN1E, . . ., etc. auf zwei Wege aufzuteilen.

Aus Fig. 4B ist zu ersehen, daß die Beginne IIN1A, IIN3A und IIN5A der ungeradzahligen Impulsintervalle einem Weg I und die Beginne IIN2A, IIN4A und IIN6A der geradzahligen Impulsintervalle einem Weg II zugeordnet werden sollen. Es sei davon ausgegangen, daß eine lückenlose Erzeugung aufeinanderfolgender Impulsintervalle mit hoher zeitlicher Auflösung (1-Nanosekunden-Zeitraster im Vergleich zum 10-Nanosekunden-Zeitraster eines verwendeten 100-MHz-Quarzoszillators) bereits nach der Patentanmeldung OS 28 29 709 möglich war. Dies jedoch nur mit der Einschränkung, daß bestimmte Totzeiten in Kauf zu nehmen waren.

Zur Klärung der Wirkungsweise der Schaltung im linken Teil von Fig. 1 sei zunächst noch einmal auf die Fign. 3A, 3B, 3C verwiesen. Für das erste Impulsintervall zwischen IIN1A und IIN1E bleibt die 10-Nanosekunden-Zeitrasterung des 100-MHz-Oszillators unverändert (Weg I); für das darauffolgende zweite Impulsintervall zwischen IIN2A und IIN2E ist jedoch eine Verschiebung des 10-Nanosekunden-Zeitrasters des 100-MHz-Oszillators um den Zeitwert TD1 (z. B. 3 Nanosekunden) erforderlich (Weg II). Im Anschluß an das zweite Impulsintervall würde das dritte Impulsintervall wieder über den Weg I, das vierte Impulsintervall über den Weg II, etc. prozessiert werden. Die Zeitwerte TD, um die die Zeitraster aufeinanderfolgender Impulsintervalle gegeneinander zu verschieben sind, werden über eine Schaltung, wie sie in der deutschen Patentanmeldung OS 28 29 709 beschrieben ist, vorgegeben. Diese zeitlichen Verschiebewerte TD werden benutzt, um eine Zeitverschiebung der entsprechenden 10-Nanosekunden-Zeitraster für die Wege I und II zu bewirken. Das von einem 100-MHz-Quarzoszillator 1 erzeugte 10-Nanosekunden-Zeitraster wird über die Leitungen 2 einer Verzögerungsschaltung DI 3 und zum anderen einer Verzögerungsleitung DII 4 zugeführt. Jede Verzögerungsschaltung ist mit einer Reihe von Abgriffen mit einer 1-Nanosekunden-Zeitstaffelung versehen. Die Ausgangsleitungen der Verzögerungsschaltung 3 sind mit 5, die der Verzögerungsschaltung 4 mit 6 gekennzeichnet. Entsprechend einem Steuerwert kann jede dieser Verzögerungsschaltungsabgriffe selektiv aktiviert werden. Die Selektion eines Verzögerungsschaltungsabgriffes der Verzögerungsschaltung 3 erfolgt über die Multiplexsteuerschaltung MPXI 7.

Die Selektion eines Verzögerungsschaltungsabgriffes der Verzögerungsschaltung 4 erfolgt über die Multiplexsteuerschaltung MPXII 8. Entsprechend den Darstellungen in Fig. 3B und 3C sei angenommen, daß für das erste Impulsintervall (Weg I) keine Verschiebung des 10-Nanosekunden-Zeitrasters erfolgen soll. Der Verschiebesteuerwert wäre demnach 0 und die 10-Nanosekunden-Rasterfolge des Quarzoszillators 1 würde über die Leitung 2, die Verzögerungsschaltung DI 3 und die oberste Leitung des Leitungsbündel 5 unverzögert auf die Leitung 42 (Weg I) überführt werden.

Gemäß der Darstellung in Fig. 3C wäre jedoch die 10-Nanosekunden-Zeitrasterfolge für den Weg II um den Zeitwert TD1, z. B. 3 Nanosekunden, zu verchieben. Dazu würde die Multiplexsteuerschaltung 8 über die Leitung 13 mit diesem Wert 3 beaufschlagt werden, was wiederum eine Selektion der vierten Leitung (von oben) des Leitungsbündels 6 bedingen würde. Dieser Leitung ist jedoch jener Verzögerungsschaltungsabgriff, auf dem die 10-Nanosekunden-Zeitrasterfolge des 100-MHz-Quarzoszillators 1 eine zeitverzögerung von 3 Nanosekunden erlangt (wie bereits erwähnt, haben die Verzögerungsschaltungsabgriffe eine Zeitstaffelung von jeweils 1 Nanosekunde. Wenn die oberste Leitung keine Zeitverzögerung aufweist, würde die darunterliegende eine Zeitvorzögerung von 1 Nanosekunde, die dritte Leitung von oben eine Zeitverzögerung von 2 Nanosekunden und die vierte Leitung von oben eine Zeitverzögerung von 3 Nanosekunden aufweisen).

Auf diese Art und Weise ist es möglich, der 10-Nanosekunden-Rasterfolge des Quarzoszillators 1, welche über die Leitung 2 der Verzögerungsschaltung 8 zugeführt wird, durch Selektion des entsprechenden Verzögerungsleitungsabgriffes eine Zeitverzögerung von 3 Nanosekunden zu erteilen. Diese zeitverzögerte 10-Nanosekunden-Zeitrasterfolge würde dann für den Weg II auf Leitung 41 zur Verfügung stehen. Es wurde bereits darauf hingewiesen, daß die Verschiebewerte für die 10-Nanosekunden-Zeitraster der einzelnen Impulsintervale bekannt sind. Diese Werte sind in Fig. 1 mit TD gekennzeichnet. Sie stellen sich als Differenz der gesamten Impulsintervallänge zu dem Gesamtzeitwert aller 10-Nanosekunden-Zeitrastereinheiten des Quarzoszillators innerhalb des Impulsintervalles dar. Die Verschiebewerte werden über die Leitung 10 vom Register 9 und danach vom Register 11 verfügbar gehalten. Durch eine entsprechende Taktsteuerung der Register 9 und 11 ist sichergestellt, daß diese Werte zeitgerecht zur Ansteuerung der Multiplexsteuerschaltungen 7 bzw. 8 zur Verfügung gestellt werden. Der Verschiebewert aus dem Register 9 gelangt über die Leitung 12 auf die Multiplexsteuerschaltung 7; der Verschiebewert aus dem Register 11 über die Leitung 13 auf die Multiplexsteuerschaltung 8. Die Taktsteuerung des Registers 9 erfolgt über die Leitung 39, die des Registers 11 über die Leitung 38. Durch die Taktsteuerung ist gewährleistet, daß zu einem Zeitpunkt immer nur ein Verschiebewert aus einem Register die zugehörige Multiplexsteuerschaltung beaufschlagt. Für das erste Impulsintervall gemäß Fig. 3D wird der für dieses Impulsintervall entsprechende verscheibewert 0 über die Leitung 12 auf die Multiplexsteuerschaltung 7 gegeben (Weg I); anschließend wird der Verschiebewert 3 für das zweite Impulsintervall über die Leitung 13 aus dem Register 11 auf die Multiplexsteuerschaltung 8 gegeben.

Im folgenden wird die Wirkungsweise des unteren linken Teiles der Schaltung Fig. 1 beschrieben. Dieser Teil dient der Aufgliederung der 10-Nanosekunden-Zeitraster aufeinanderfolgender Impulsintervalle auf die Wege I und II. Zum besseren Verständnis der Wirkungsweise der Schaltung sei wiederum auf Fig. 4 verweisen. Es sei vorausgesetzt, daß die einzelnen jeweils Impulsintervallbeginn und Impulsintervallende kennzeichnenden Größen IIN auf Leitung 15 (Fig. 1) verfügbar sind. Mit anderen Worten: Auf Leitung 15 würde eine Information gemäß Fig. 4A gegeben werden.

Aufgabe der Schaltung ist es, diese enzelnen Werte auf die Wege I und II so aufzuteilen, wie es in Fig. 4B für Weg I und in Fig. 4C für Wege II vorgegeben ist. Diese Aufgabe wird mit Hilfe eines sogenannten JK-Flip-Flops 14 gelöst. Dieses Flip-Flop hat einen Eingang 15 und zwei Ausgänge, den Q-Ausgang (Leitung 18) und den $\overline{Q}$-Negationsausgang (Leitung 19). Das JK-Flip-Flop soll z. B. auf eine positive Flanke der IIN-Impulse ansprechen. Für den ersten IIN-Impuls auf Leitung 15 erzeugt das Flip-Flop am Q-Ausgang (Leitung 18) ebenfalls einen positiven Wert. Die Leitung 18 wird einem UND-Glied 20 zugeführt, dessen zweiter Eingang 16 mit dem Eingang 15 des Flip-Flops 14 verbunden ist. Für den Fall, daß auf Leitung 18 ebenso wie am Eingang 15 des Flip-Flops 14 ein positiver Wert erscheint (eine Zeitverschiebung sei hier vernachlässigt), liefert das UND-Glied 20 für den Weg I einen Ausgangsimpuls auf Leitung 22, der in der Darstellung Fig. 4B IIN1A entsprechen würde. Nach dem Auftreten des zweiten IIN-Impulses (nach Fig. 4A handelte es sich dann um IIN1E=IIN2A) lieferte das Flip-Flop 14 an seinem $\overline{Q}$-Negationseingang (Leitung 19) einen positiven Puls, der sich über das UND-Glied 21, dessen zweiter Eingang 18 ebenfalls mit dem Eingang 15 des Flip-Flops 14 verbunden ist, auf Weg II (Leitung 23) als IIN2A-Puls (Fig. 4C) fortsetzen würde. (Das JK-Flip-Flop 14 schaltet mit jeder positiven Eingangspulsflanke seine Ausgänge Q bzw. $\overline{Q}$ alternierend auf einen positiven Ausgangswert).

In Analogie ergeben sich für den Weg I und den Weg II auf den Leitungen 22 und 23 für die einzelnen Impulsintervalle die in Fig. 4B bzw. Fig. 4C dargestellten Verhältnisse. Auf diese Weise ist es möglich, die Folge der die einzelnen Impulseintervalle kennzeichnenden Anfangs- und Endpulse gemäß Fig. 4A in eine für den Weg I (Fig. 4B) und in den Weg II (Fig. 4C) entsprechenden Weise aufzugliedern. Mit dem Auftreten der Ausgangssignale am Q- bzw. Q̄-Ausgang des Flip-Flops 14 auf den Leitungen 18 und 19 werden die Register 9 und 11 getaktet. Angenommen, der Verschiebewert TD=O für das erste Impulsintervall stünde am Eingang der Register 9 und 11 an. Das Auftreten des Impulses IIN1A auf Leitung 18 würde über Leitung 39 eine Taktung des Registers 9 bewirken; der Wert TD=O würde über die Leitung 12 die Multiplexsteuerschaltung I7 ansteuern. Zu dem darauffolgenden Zeitpunkt während des Auftretens des Impulses IIN2A auf Leitung 19 würde das Register 11 durch diesen Impuls über die Leitung 38 getaktet werden, so daß der auf diese Weise geladene Verschiebewert über die Leitung 13 der Multiplexsteuerschaltung 8 zugeführt wird.

Die Information auf der Leitung 22 wird über ein Verzögerungsglied 24 und die Leitung 26 auf ein Flip-Flop 30 gegeben und über dessen Ausgangsleitung 32 einem UND-Glied 34 zugeführt. Der zweite Eingang dieses UND-Gliedes 34 ist mit der Leitung 42 verbunden. Das UND-Glied 34 hat die Aufgabe, das 10-Nanosekunden-Zeitraster auf der Leitung 42 für das erste Impulsintervall durchzuschalten. Diese wird auf folgende Art und Weise bewerkstelligt: Wenn der Impuls IIN1A auf Leitung 22 das Flip-Flop 30 beaufschlagt, so wird am Q-Ausgang dieses Flip-Flops auf Leitung 32 ein das UND-Glied 34 beaufschlagende Ausgangssignal gebildet. Dieses Ausgangssignal bleibt so lange stehen, bis das Flip-Flop über Leitung 27 zurückgesetzt wird. Mit anderen Worten: Steht auf Leitung 32 ein Signal an, so kann sich das 10-Nanosekunden-Zeitraster auf Leitung 42 über das UND-Glied 34 auf dessen Ausgangsleitung 36 durchsetzen. Das Rücksetzen des Flip-Flops 30 wird an anderer Stelle etwas ausgesagt. Da sich beim Umschalten des 10-Nanosekunden-Zeitrasters von einem Abgriff der Verzögerungsleitung 3 bzw. 4 auf einen anderen Einschwingvorgänge ergeben, ist es wünschenswert, das Zeitraster erst dann das UND-Glied 34 passieren zu lassen, wenn die Einschwingvorgänge abgeklungen sind. Aus diesem Grunde soll das UND-Glied 34 erst nach einer entsprechenden Verzögerungszeit, die durch das Flip-Flop 30 schaltungsmäßig bedingt ist, durchlässig werden. Sollte sich diese Verzögerungszeit des Flip-Flops 30 als zu klein erweisen, wird ein weiteres Verzögerungsglied 24 vorgesehen.

Die vorstehenden Ausführungen gelten in analoger Weise auch für den Weg II, soweit das Durchschalten des für das zweite Impulsintervall um 3 Nonosekunden zeitverschobenen 10-Nanosekunden-Rasters auf Leitung 41 über das UND-Glied 35 auf Leitung 37 betroffen ist. Dem UND-Glied 35 ist ein Verzögerungsglied 25 und ein Flip-Flop 31 vorgeschaltet. Die Verbindungsleitung zwischen dem Verzögerungsglied 25 und dem Flip-Flop 31 ist mit 28, die Verbindungsleitung des Flip-Flops 31 mit den UND-Glied 35 mit 33 gekennzeichnet. Das Verzögerungsglied 25 ist mit der Ausgangsleitung des UND-Gliedes 21 verbunden. Die Funktionen der einzelnen Elemente für den Weg I und Weg II entsprechen einander. Das Flip-Flop 31 wird über den Impuls IIN2A erstmals angesteuert und später über Leitung 29 zurückgesetzt. Nach der Ansteuerung steht an seinem Ausgang 33 ein Signal an, welches das UND-Glied 35 für das zweite Impulsintervall für das 10-Nanosekunden-Zeitraster auf Leitung 41 durchlässig macht. Das Flip-Flop 31 wird am Ende des zweiten Impulsintervalles über die Leitung 29 zurückgesetzt.

Auf diese Weise stehen auf den Leitungen 36 und 37 während der einzelnen Impulsintervalle die, wenn erforderlich, verschobenen 10-Nanosekunden-Zeitraster in einer Weise zur Verfügung, daß der Beginn jedes Impulsintervalles mit einer 10-Nanosekunden-Zeitrastermarke zusammenfällt. Entsprechend den Wegen I und II stehen die 10-Nanosekunden-Zeitraster für die geradzahligen Impulsintervalle auf Leitung 36 und für die ungeradzahligen Impulsintervalle auf Leitung 37 alternierend zur Verfügung.

Nachdem beschrieben wurde, wie die 10-Nanosekunden-Zeitraster für aufeinanderfolgende Impulsintervalle jeweils eine Zeitverschiebung erfahren können, wird nunmehr auf die Erzeugung einzelner Impulse innerhalb der Impulsintervalle eingegangen. Ein Teillösung zu dieser Aufgabe wurde bereits in Der Deutschen Offenlegungsschrift OS 28 29 709 insbesondere in Zusammenhang mit der dortigen Fig. 10 aufgezeigt. Danach wurde ein Impulsintervall-Beginnimpuls (in der OS 28 29 709 Zyklusbeginnimpuls genannt) dazu benutzt, um in zeitlicher Relation zu seiner Anstiegsflanke während eines vorliegenden Impulszyklus einen Impuls vorgegebener Impulsbreite und mit vorgegebenem Abstand zur Zyklusbeginn-Impulsanstiegsflanke zu erzeugen. Dazu wurde der Zyklusbeginnimpuls einem Verzögerungsglied zugeführt. Das Verzögrungsglied weist an seinem Ausgang eine Vielzahl von Ausgangsleitungen auf. Jede dieser Ausgangsleitungen ist einer bestimmten Verzögerungszeit zugeordnet. Die Vielzahl dieser Ausgangsleitungen führt auf eine Multiplexsteuerschaltung. Diese Multiplexsteuerschaltung erhält von einem programmierbaren Speicher die Anweisung, welche Ausgangsleitung der Verzögerungsgliedes für eine bestimmte Verzögerungszeit auszuwählen ist. Die ausgewählte Verzögerungsleitung wird von der Multiplexsteuerschaltung auf deren Ausgang durchgeschaltet und einem Flip-Flop zugeführt. Beim Auftreten der verzögerten Anstiegsflanke des Zyklusbeginnimpulses schaltet das Flip-Flop durch, so daß an seinem Ausgang ein Spannungssprung auftritt. Dieser Spannungssprung stellt den Beginn des innerhalb eines Zyklus zu erzeugenden Impulses dar. Das Impulsende wird durch folgende Maßnahmen festgelegt: Mit dem Ausgang der Multiplexsteuerschaltung ist ein zweites Verzögerungsglied verbunden, welches wiederum eine Vielzahl von Ausgangsleitungen aufweist, die unterschiedlichen Verzögerungszeiten zugeordnet werden. Diese Leitungen führen auf eine zweite Multiplexsteuerschaltung, die wiederum mit einem programmierbarn Speicher verbunden ist. Beim Auftreten der verzögerten Anstiegsflanke des Zyklusbeginnimpulses wird nun diese Flanke durch das zweite Verzögerungsglied auf einen Wert verzögert, welcher durch den programmierbaren Speicher der zweiten Multiplexsteuerschaltung vorgegeben ist. Am Ausgang der zweiten Multiplexsteuerschaltung steht dann die (noch mehr als durch die erste Multiplexsteuerschaltung verzögerte Zyklusbeginnimpuls-Anstiegsflanke) zur Verfügung. Diese wird dem bereits erwähnten Flip-Flop zugeführt, das daraufhin an seinem Ausgang den durch die erste verzögerte Zyklusbeginnimpuls-Anstiegsflanke bedingten Spannungssprung zurücknimmt und so die Erzeugung des Impulses während eines Impulsintervalls abschließt. Auf diese Weise konnte durch eine entsprechend programmierte Vorgabe der Verzögerungszeiten ein Impuls vorgegebener Breite und mit vorgegebenem Abstand zur Anstiegsflanke des Zyklusbeginnimpulses erzeugt werden. Die Impulserzeugung innerhalb eines Zyklus war somit immer auf den Zyklusbeginnimpuls rückbezogen. Durch die Angaben im Speicher wurden nicht nur die Zyklusbeginnzeitpunkte festgelegt, sondern auch die innerhalb der einzelnen Zyklen zu erzeugenden Impulse. Diese Werte konnten bezüglich der Impulsbreite und des Abstandes zum Zyklusbeginn variieren.

Von dieser bereits vorbekannten Möglichkeit zur Erzeugung eines Impulses innerhalb eines Zyklus wird auch hier im Rahmen des sogenannten Zwei-Wege-Verfahrens Gebrauch gemacht:

Im folgenden wird beschrieben, wie der Impuls für den ersten Zyklus erzeugt wird. Da diese Maßnahme an den Weg I geknüpft ist, sie von der Leitung 36 ausgegangen, auf der das 10-Nanosekunden-Zeitraster für das erste Impulsintervall zur Verfügung steht. Dieses 10-Nanosekunden-Zeitraster beaufschlag über die Leitung 36 einen Abwärtszähler 45 und einen Abwärtszähler 47. Der Zähler 45 dient der Erzeugung der Anstiegsflanke des im ersten Zyklus zu erzeugenden Impulses, während der Zähler 47 der Erzeugung seiner Abfallflanke dient. Der Zähler 45 wird vor Beginn des ersten Zyklus aus einem Speicher 43 über die Leitung 56 mit einem Zeitwert geladen, welcher den zeitlichen Abstand der Impulsanstiegsflanke vom Impulsintervallbeginn entspricht, allerdings nur, soweit die geradzahlige Anzahl der 10-Nanosekunden-Rastereinheiten betroffen ist. Analoges gilt für den Zähler 47, der aus dem Speicher 44 über die Leitung 70 mit einem Zeitwert geladen wird, welcher dem Abstand der Impulsabfallflanke zum Impulsintervallbeginn entspricht, allerdings nur, soweit die geradzahlige Anzahl der 10-Nanosekunden-Rastereinheiten betroffen ist. Mit dem Auftreten der ersten 10-Nanosekunden-Rastermarke innerhalb des ersten Impulsintervalles beginnen die Zähler 45 und 47 abwärts zu zählen. Jede weitere 10-Nanosekunden-Rastermarke bedeutet für die Zähler einen weiteren Takt für den Abwärtszählvorgang. Beim Erreichen des Zählerstandes O liefert der Zähler 45 auf seiner Ausgangsleitung 76 ein Signal, welches einem ersten Eingang eines ODER-Gliedes 49 zugeführt wird. Des weiteren dient dieses Signal über die Leitung 58, 59 dem Rücksetzen des Zählers 45 und einem neuen Ladevorgang aus dem Speicher 43 für das dritte Impulsintervall. Das Zählerausgangssignal wird über das ODER-Glied 49 und die Leitung 61 einer Verzögerungsschaltung 51 zugeführt. Diese Verzögerungsleitung hat eine Reihe von Verzögerungsleitungsabgriffen mit einer entsprechenden Staffelung der Verzögerungswerte. Im gewählten Beispiel soll die Zeitstaffelung dieser Verzögerungsleitungsabgriffe jeweils 1 Nanosekunde betragen. D. h. die zeitliche Auflösung der Verzögerungsleitungsabgriffe ist größer als das zeitliche 10-Nanosekunden-Rastermaß des verwendeten 100-Hz-Quarzoszillators. Die Auswahl eines Verzögerungsleitungsabgriffes erfolgt über eine Multiplexsteuerschaltung 53. Den Steuerwert für die zeitliche "Feinverzögerung" des durch den Zähler 45 erzeugten Anstiegsflankensignales erhält die Multiplexsteuerschaltung über die Leitung 63 aus dem Speicher 43. In diesem Speicher ist auch die Anzahl der 10-Nanosekunden-Rasterschritte zur Ansteuerung der Zählers 45 (und 46) gespeichert. Die durch Auswahl eines entsprechenden Verzögerungsleitungsabgriffes verzögerte Impulsanstiegsflanke steht am Ausgang der Multiplexsteuerschaltung 53 auf der Leitung 64 zur Verfügung und wird einem Flip-Flop 55 zugeführt. Beim Auftreten eines Signales auf der Leitung 64 wird der Q-Ausgang 65 des Flip-Flops 55 gesetzt, was dem Beginn des zu erzeugenden Impulses innerhalb des ersten Zykluses gleichkommt. Dieses Signal auf der Leitung 65 wird erst dann zurückgenommen, wenn auf der zweiten Eingangsleitung 66 dieses Flip-Flops 55 ein das Impulsende signalisierendes Signal auftritt. Die Erzeugung dieses Signals erfolgt in analoger Weise zu dem vorhergesagten über den Zähler 47. Erreicht dieser Zähler während des Abwärtszählvorganges den Wert O, so erzeugt er auf seiner Ausgangsleitung 75 ein Signal, welches einerseits über das ODER-Glied 50 und die Leitung 77 einer Verzögerungsleitung 52 zugeführt wird, welche eine Reihe von Verzögerungsleitungsabgriffen 79 aufweist. Die Auswahl einer dieser Verzögerungsleitungsabgriffe erfolgt über die Multiplexsteuerschaltung 54, welche ihren Steuerwert über die Leitung 67 aus dem Speicher 44 erhält. Das entsprechend feinverzögerte Impulsabfall-Flankensignal wird über die Ausgangsleitung 66 der Multiplexsteuerschaltung 54 dem Flip-Flop 55 zugeführt. Außerdem dient das Zählerausgangssignal auf Leitung 75 über die Leitungen 68 und 69 dem Zurücksetzen des Zählers 47 bzw. seinem erneuten Laden mit einem Wert aus dem Speicher 44 für den dritten Zyklus. Das Signal auf Leitung 75 wird über die Leitung 68 (mit dem Anschlußpunkt A) zum Zurücksetzen des Flip-Flops 30 verwendet. Auf diese Weise wird der Impuls im ersten Impulsintervall erzeugt. Zur Erzeugung des Impulses im nachfolgenden zweiten Impulsintervall dienen die Zähler 46 und 48. Vor Beginn des zweiten Impulsintervalles wird der Zähler 46 mit entsprechenden Werten aus dem Speicher 43 über die Leitung 57 geladen, soweit die geradzahlige Anzahl der 10-Nanosekunden-Rastereinheiten betroffen ist. Entsprechendes gilt für die Impulsabfallflanke des während des zweiten Impulsintervalles zu erzeugenden Impulses. Hierfür wird der Zähler 48 mit entsprechenden Zeitwerten über die Leitung 71 aus dem Speicher 44 geladen. Mit jedem Auftreten einer 10-Nanosekunden-Rastermarke für das zweite Impulsintervall auf der Leitung 37 werden die Zähler 46 und 48 entsprechend abwärtsgezählt. Beim Erreichen des Standes O gibt der Zähler 46 über seine Ausgangsleitung 60 und das ODER-Glied 49 ein entsprechendes Signal auf die Verzögerungsschaltung 51. Dieses Signal wird einer entsprechenden Feinverzögerung unterworfen, wobei der Verschiebewert wiederum aus dem Speicher 43 an die die Auswahl des entsprechenden Verzögerungsleitungsabgriffes bewirkenden Multiplexsteuerschaltung 53 geliefert wird. Nach Erreichen des Zählerstandes O für den die Impulsabfallflanke bestimmenden Zählers 48 erscheint auf dessen Ausgangsleitung 74 ein ignal, welches in entsprechender Weise über das ODER-Glied 50 die Leitung 77 der Verzögerungsschaltung 52 für eine entsprechende zeitliche Zeitfeinverzögerung zugeführt wird (Signal auf Leitung 74 (Punkt B) bringt FF 31 wieder in Grundstellung).

Es sei wiederholend bemerkt, daß die Erzeugung der Impulse für die ungeradzahligen Impulsintervalle über den Weg I erfolgt, während die Erzeugung der Impulse für die geradzahligen Zyklen auf dem Weg II erfolgt. Die Erzeugung der Impulse in unmittelbar aufeinanderfolgenden Impulsintervallen kann ganz oder teilweise zeitlich überlappt erfolgen.

Daß die Ausgänge der Zähler 45 und 46 zur Erzeugung der Impulsanstiegsflanken über das ODER-Glied 49 zusammengeführt werden, hat den Vorteil, daß nachfolgend nur eine Verzögerungsleitung 51 mit der zugehörigen Multiplexsteuerschaltung 53 zur Erzeugung einer zeitlichen Feinrasterung zu verwendet werden braucht. Im anderen Falle (nicht dargestellt), wenn also die Ausgänge der Zähler 45 und 46 getrennt über eine ihnen zugeordnete Verzögerungsleitung geführt würden, müßten letztere absolut kongruent arbeiten, um ein zeitliches Auswandern der Anstiegsflanken zu verhindern (entsprechendes gilt natürlich in Analogie für die Zähler 47 und 48 in Verbindung mit der ihnen nachgeschalteten Verzögerungsschaltung 52 und der ihr zugeordneten Multiplexsteuerschaltung 54).

Bei der in Fig. 1 beschrieben Schaltung sind die erzeugten Impulse exakt reproduzierbar. Mit anderen Worten, die Genauigkeit der vom 10-Nanosekunden-Zeitraster bestimmten Information ist quarz(1)-genau; die durch die Verzögerungsleitungen 51 und 52 bedingten zeitlichen Feinrasterungen unterliegen der Genauigkeit dieser Verzögerungsleitungen.

Die Wiederholgenauigkeit der erzeugten Impulse ist also vom verwendeten Quarzoszillator 1 bestimmt.

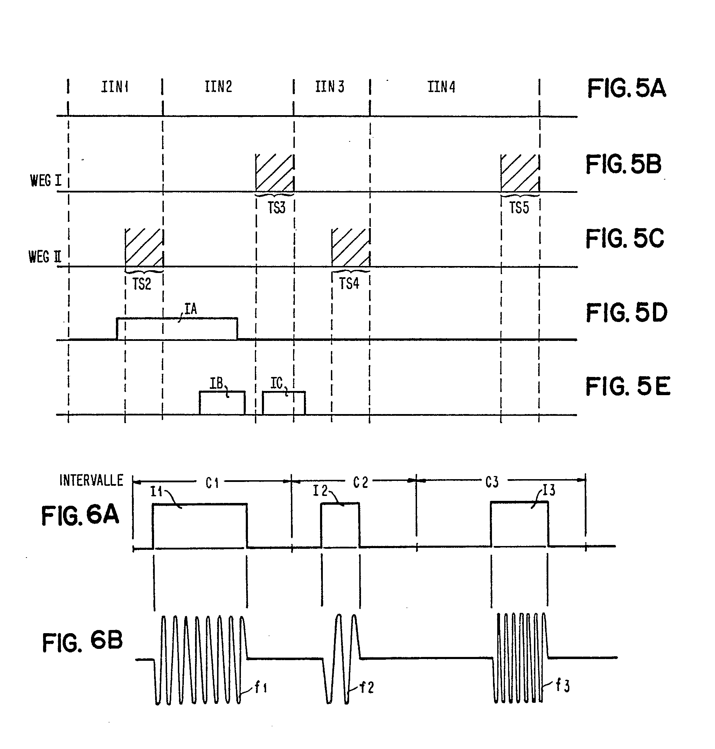

Zur weiteren Erklärung der Vorzüge des beschriebenen Systemes zur Erzeugung beliebiger Wunschimpulsmuster sei auf Fign. 5A bis 5E verwiesen. In Fig. 5A sind aufeinanderfolgende Impulsintervalle (IIN1, IIN2, IIN3, IIN4) schematisch dargestellt.

Aus den Fign. 5B und 5C geht hervor, wie man sich diese Impulsintervalle auf die verschiedenen Wege I und II verteilt verstellen kann. Die ungeradzahligen Impulsintervalle werden vom Weg I, die geradzahligen vom Weg II erfaßt. Die im Zusammenhang mit Fig. 1 bezüglich der Verzögerungsschaltung 3 und 4 erwähnten "Einschwingvorgänge" sind mit TS2, TS3, TS4, TS5 gekennzeichnet. Diese "Einschwingzeiten" TS sollen jeweils vor Beginn der für den einzelnen Weg I oder II maßgebenden Impulsintervalle liegen. Die innerhalb der einzelnen Impulsintervalle zu erzeugenden Impulse auf dem Weg I dürfen sich nicht in die Zeiträume TS erstrecken; entsprechendes gilt für die innerhalb der einzelnen Impulsintervalle zu erzeugenden Impulse auf Weg II.

Ein zu erzeugender Impuls IA (siehe Fig. 5D) kann sich über das erste Impulsintervall IIN1 (Weg I) hinaus in das zweite Impulsintervall IIN2 (Weg II) erstrecken.

Ebenso ist es aber nach möglich (siehe Fig. 5E), auf dem Weg I einen Impuls IB so zu erzeugen, daß er zeitlich in das zweite Impulsintervall IIN2 fällt. Soll dieser Impuls IB nun von einem weiteren zu erzeugenden Impuls IC gefolgt werden, so ist dieser Impuls IC auf dem Weg II zu erzeugen. Dabei ist es wiederum möglich, die Erzeugung eines solchen Impulses über das zweite Impulsintervall hinaus in das dritte Impulsintervall (wieder Weg I) zu erstrecken.

Ein Überlappen der "Einschwingzeiten" TS für die Wege I und II kann nicht auftreten, weil die Verzögerungsleitungen 3, 4 nicht überlappend arbeiten.

Es ist also möglich, einen zu erzeugenden Impuls aus auf den Wegen I und II erzeugten Teilimpulsen zusammenzusetzen (Fig. 5D). Dabei setzt sich ein in einem Impulsintervall begonnener Impuls im darauffolgenden Impulsintervall fort.

Des weiteren ist es möglich, ein in einem Impulsintervall programmierten Impuls erst im darauffolgenden Impulsintervall auftreten zu lassen (siehe Impuls IB in Fig. 5E).

Ein in einem Impulsintervall programmierten Impuls kann selbstverständlich auch im gleichen Impulsintervall auftreten (Fig. IC in Fig. 5E).

Auf diese Weise können Doppelimpulse für extrem kurze Impulsintervalle erzeugt werden. Die für die Impulserzeugung verbotenen Zonen der "Einschwingzeiten" TS wirken sich nach dem Zwei-Wege-Verfahren für die Impulserzeugung nicht nachteilig aus, so daß programmierbare fortlaufende Impulsmuster höchster Zeitauflösung und Genauigkeit ohne Totzeiten erzeugt werden könne.

Es sei darauf hingewiesen, daß sich die Anwendung der erfindungsgemäßen Schaltung insbesondere auf den Bereich des Austestens schneller Speicherprodukte oder schneller Logikschaltungen erstreckt. Dabei wirkt es sich als besonders vorteilhaft aus, beliebig vorzugebende Impulsmuster ohne Kenntnis der Hardware zu programmieren.

Wenn im Ausführungsbeispiel von einer 1-Nanosekunden-Auflösung gesprochen wird, so bleibt auch für künftig schnellere Schaltkreise (die noch zu entwickeln sind) das erfindungs-gemäße Schaltungsprinzip erhalten. Danach ist eine zeitliche Feinrasterung in Ableitung von einer vorgebbaren schaltkreistechnologisch gebundenen Grobrasterung möglich.

Außerdem kann die beschriebene Schaltung auch zum zeitlich unmittelbar aufeinanderfolgenden Umschalten von Frequenzen (z. B. zum Umschalten von Sendefrequenzen) oder auch zur schaltunsgesteuerten Erzeugung von Frequenzen, auch im Tonbereich, Anwendung finden.

Aus Fig. 6A geht hervor, daß innerhalb programmierbarer Impulsintervalle C1, C2, C3, wie sich nach der Erfindung erzeugt werden könne, die Impulse I1, I2 und I3 vorgegeben werden können.

Wie aus Fig. 6B zu ersehen ist, können die Impulse I1, I2 und I3 dazu benutzt werden, gleiche oder unterschiedliche Sendefrequenzen f1, f2, f3 zu tasten. Wird den Impulsen I1, I2 und I3 eine Länge gegeben, die nahezu der Länge der Impulszyklen C1, C2 und C3 entspricht, so ist es möglich, gleiche oder unterschiedliche Sendefrequenzen nahtlos (und ohne Einschwingvorgänge) zu schalten.

In diesem Zusammenhang sei bemerkt, daß die Tastung von Sendefrequenzen durch entsprechende Impulse zum Stand der Technik gehört, jedem Fachmann geläufig ist und deshalb in diesem Zusammenhang nicht näher beschrieben wird.

Ebenso ist es möglich, die Frequenzen f1, f2 bzw. f3 (in Fig. 6B) einer Frequenzmodulation zu unterwerfen (bei der Modulation einer Trägerfrequenz tritt bekanntlich ein diskretes Frequenzspektrum auf).

Die Tastung bzw. Modulation kann entweder mit dem Anfang der die Impulse bzw. mit dem Anfang der die Impulsintervalle kennzeichnenden Signale einsetzen.

Die Möglichkeit des programmierbaren Umschaltens von Trägerfrequenzen (Sendefrequenzen) ermöglicht eine "geheime" Übermittlung von Information, wenn die programmierbare Umschaltung von einer Sendefrequenz zur anderen nur der Sende- und Empfangsseite bekannt ist.

Die Erzeugung von Frequenzen kann sich auch auf den niederen Frequenzbereich (hörbaren Tonbereich) erstrecken. Das Prinzip der Erzeugung von Tonfrequenzen ist das gleiche wie bei der Erzeugung von hohen Frequenzen im Megahertzbereich. Damit eröffnet sich die Möglichkeit, Tonfrequenzen zu erzeugen und ohne Einschwingvorgänge nahtlos umzuschalten. Normalerweise werden Einschwingvorgänge vom menschlichen Ohr durch seine Trägheit als nicht störend empfunden. Jedoch ist eine Erzeugung von Tonfrequenzen und deren Umschaltung ohne Einschwingvorgänge für meßtechnische Belange von Interesse.

**Patentansprüche**

1. Verfahren zur totzeitlosen Erzeugung von in aufeinanderfolgenden Impulsintervallen (IN1, IN2, . . .; IIN1, IIN2, . . .) auftretenden Impulsen (I1, I2, . . .; $I_A$, $I_B$, $I_C$) bei hoher zeitlicher Auflösung der Impulsintervalle und der Impulse, dadurch gekennzeichnet,

daß über einen zeitliche Grobrasterwerte vorgebenden Oszillator (1) und diesem zur zeitlichen Feinrasterung nachgeschltete, in Abhängigkeit von gespeicherten nachgeschaltete, in Abhängigkeit von gespeicherten Zeitwerten gesteuerte Verzögerungsschaltungen (3, 4) mit selektiv auswählbaren (7, 8) Verzögerungsschaltungsabgriffen (5, 6) Anfang (IIN1A, IIN2A) und Ende (IIN1E, IIN2E) eines Impulsintervalles kennzeichnende Signale begildet werden,

daß die die Impulsintervalle kennzeichnenden Signale alternierend jeweils einem von zwei Wegen (Weg. I, Weg II) in einer Weise zugeführt werden,

daß das den jeweiligen Impulsintervallanfang kennzeichnende Signal mit dem durch den Oszillator (1) vorgegebene zeitlichen Grobraster übereinstimmt,

daß für jeden Weg die Anstiegs- und Abfallflanke eines innerhalb eines Impulsintervalles zu bildenden Impulses über vom Takt des Oszillators (1) getriebene und von einem Speicher (43 bzw. 44) mit einem Zählwert ladbare Zähler (45, 46 bzw. 47, 48) bei der Erreichung eines bestimmten Zählerstandes abgeleitet wird,

daß den Zählern (45, 46 bzw. 47, 48) für die Bildung der Anstiegs- bzw. Abfallflanke jeweils eine gemeinsame Verzögerungsschaltung (51 bzw. 52) mit speichergesteuert (43 bzw. 44), selektiv auswählbaren Verzögerungsschaltungsabgriffen (62 bzw. 79) zur zeitlichen Feinrasterung nachgeschaltet ist, und daß die auf beiden Wegen alternierend erzeugte Impulsinformation auf einer gemeinsamen Leitung (65) zusammengeführt wird.

2. Verfahren nach Anspruch 1, gekennzeichnet durch die Anwendung zum Austesten schneller Speicherprodukte oder schneller logischer Schaltungen.

3. Verfahren nach einem der Ansprüche 1 bis 2, dadurch gekennzeichnet, daß die innerhalb der Impulsintervalle erzeugten Impulse zur Tastung von gleichen oder unterschiedlichen Frequenzen benutzt werden.

4. Verfahren nach einem der Ansprüche 1 bis 2, dadurch gekennzeichnet, daß die den Anfang der Impulse oder Impulsintervalle kennzeichnenden Signale zur Erzeugung eines diskreten Frequenzspektrums verwendet werden.

5. Verfahren nach einem der Ansprüche 1 bis 2, dadurch gekennzeichnet, daß die aus einem Speicher verfügbaren Werte für die Zeitrelationen der Impulsintervalle und Impulse per Programmbefehl vorgegeben werden.

6. Verfahren nach einem der Ansprüche 1, 2 oder 5, dadurch gekennzeichnet, daß sich der zu erzeugende Impuls (IA) von einem Impulsintervall (IIN1) in das nachfolgende Impulsintervall (IIN2) fortsetzt.

7. Verfahren nach einem der Ansprüche 1, 2 oder 5, dadurch gekennzeichnet, daß während eines Impulsintervalles (IIN1; IIN2) die Speicherwerte zur Erzeugung eines Impulses (IB; IC) vorgegeben werden, der zeitlich im nachfolgenden Impulsintervall (IIN2; IIN3) liegt.

8. Anordnung zur Durchführung des Verfahrens nach einem der Ansprüche 1 bis 7, mit einer Oszillatorschaltung (1), dadurch gekennzeichnet, daß die Oszillatorschaltung (1) mit einer ersten Verzögerungsschaltung (3) und einer zweiten Verzögerungsschaltung (4) verbunden ist, daß jede dieser Verzögerungsschaltungen (3, 4) eine Reihe von Abgriffen (5, 6) für unterschiedliche Verzögerungswerte aufweist, die speichergesteuert über jeweils eine Multiplexsteuerschaltung (7, 8) selektiv auswählbar sind, daß ein den Weg I kennzeichnender Ausgang der Multiplexsteuerschaltung (7) einem ersten UND-Glied (34) und daß ein den Weg II kennzeichnender Ausgang der Multiplexsteuerschaltung (8) einem zweiten UND-Glied (35) zugeführt wird, daß die die Impulsintervalle definierenden Signale über eine bistabile Kippschaltung (14) alternierend den UND-Gliedern (34) und (35) zugeführt werden, daß der Ausgang des ersten UND-Gliedes (34) mit einem über einen Speicher (43) nachladbaren Zähler (45) zur Bildung der Anstiegsflanke eines über den Weg I zu bildenden Impulses und mit einem über einen Speicher (44) nachladbaren Zähler (47) zur Bildung der Abfallflanke dieses Impulses verbunden ist und daß der Ausgang des UND-Gliedes (35) mit einem über den Speicher (43) nachladbaren Zähler (46) zur Bildung der Anstiegsflanke eines über den Weg II zu bildenden Impulses und mit einem über den Speicher (44) nachladbaren Zähler (48) zur Bildung der Abfallflanke dieses Impulses verbunden ist, daß die Ausgänge dieser für die Bildung der Anstiegs- bzw. Abfallflanken vorgesehenen Zähler (45 und 46 bzw. 47 und 48) jeweils mit einer gemeinsamen Verzögerungsschaltung 51 bzw. 52) verbunden sind, von denen jede eine Reihe von Abgriffen (62 bzw 79) für unterschiedliche Verzögerungswerte aufweist, die speichergesteuert über jeweils eine weitere Multiplexsteuerschaltung (53 bzw. 54) selektiv auswählbar sind, und

daß die Ausgänge beider Multiplexsteuerschaltungen (53, 54) zusammengeführt (65) sind.

9. Anordnung nach Anspruch 8, dadurch gekennzeichnet, daß die Zähler (45, 46, 47, 48) Abwärtszähler sind.

10. Anordnung nach Anspruch 8, dadurch gekennzeichnet, daß die Ausgänge (64, 66) der Multiplexsteuerschaltungen (53, 54) über eine bistabile Kippschaltung (55) zusammengeführt sind.

11. Anordnung nach Anspruch 8, dadurch gekennzeichnet, daß den UND-Gliedern (34, 35) jeweils eine Verzögerungsschaltung (24, 25) vorgeschaltet ist.

12. Anordnung nach Anspruch 8 und 11, dadurch gekennzeichnet, daß den UND-Gliedern (34, 35) jeweils eine mit den Ausgängen der Zähler (45, 46, 47, 48) verbundene Kippschaltung vorgeschaltet ist.

**Revendications**

1. Procédé pour produire sans temps mort des impulsions (I1, I2, . . .; $I_A$, $I_B$, $I_C$) se produisant à intervalles successifs (IN1, IN2, . . .; IIN1, IIN2, . . .), avec une grande résolution temporelle des intervalles entre impulsions et des impulsions, caractérisé en ce que des signaux caractérisant le début (IIN1A, IIN2A) et la fin (IIN1E, IIN2E) d'un intervalle d'impulsions sont engendrés par l'intermédiaire d'un oscillateur (1) prédéterminant des valeurs temporelles de trame grossière et de circuits de retardement (3, 4), branchés en série avec celui-ci en vue d'un tramage temporel fin, commandés en fonction de valeurs de temps mémorisées et comportant des accès (5, 6) pouvant être choisis sélectivement (7, 8),

en ce que les signaux caractérisant les intervalles entre impulsions sont introduits alternativement respectivement dans une desdeux voies (Voie I, Voie II) d'une manière telle que,

le signal caractérisant le début d'un intervalle entre impulsions correspondant concorde avec la trame grossière temporelle prédéterminée par l'oscillateur (1),

en ce que pour chaque voie le flanc montant et le flanc descendant d'une impulsion à produire à l'intérieur d'un intervalle sont établis par l'intermédiaire d'un compteur (45, 46 ou 47) actionné à la cadence de l'oscillateur (1) et pouvant être chargé avec une valeur numérique par une mémoire (43 ou 44), lorsqu'une valeur de compte déterminé est atteint,

en ce qu'il est prévu, en série avec les compteurs (45, 46 ou 47, 48) servant à établir le flanc montant ou le flanc descendant, respectivement un circuit commun de retardement (51 ou 52) comportant des accès de circuits de retardement (62 ou 79) commandés par mémoire (43 ou 44) et pouvtant être choisis sélectivement envue d'un tramage fin temporel,

et en ce que les informations correspondant aux impulsions produites alternativement dans les deux voies sont combinées dans un conducteur commun (65).

2. Procédé selon la revendication 1, caractérisé par son utilisation pour tester des éléments de mémorisation rapide ou des circuits logiques rapides.

3. Procédé selon l'une des revendications 1 et 2, caractérisé en ce que les impulsions produites à l'intérieur des intervalles entre impulsions sont utilisées pour la reconnaissance de fréquences identiques ou différentes.

4. Procédé selon l'une des revendications 1 et 2, caractérisé en ce que les signaux caractérisant le début des impulsions ou des intervalles entre impulsions sont utilisés pour produire un spectre discret de fréquences.

5. Procédé selon l'une des revendications 1 et 2, caractérisé en ce que les valeurs disponibles dans une mémoire pour les relations temporelles entre les intervalles et les impulsions sont prédéterminées par une instruction de programme.

6. Procédé selon l'une des revendications 1, 2 ou 5, caractérisé en ce que l'impulsion à produire (IA) se prolonge d'un intervalle entre impulsions (IIN1) dans l'intervalle entre impulsions suivant (IIN2).

7. Procédé selon l'une des revendications 1, 2 ou 5, caractérisé en ce que, pendant un intervalle entre impulsions (IIN1; IIN2), les valeurs en mémoire sont prédéterminées pour la génération d'une impulsion (IB; IC), qui est placée temporellement dans l'intervalle entre impulsions suivant (IIN2; IIN3).

8. Dispositif pour la mise en oeuvre du procédé selon l'une des revendications 1 à 7, comportant un circuit oscillateur (1), caractérisé en ce que le circuit oscillateur (1) est relié à un premier circuit de retardement (3) et à un second circuit de retardement (4), en ce que chacun de ces circuits de retardement (3, 4) comporte une série d'accès (5, 6) pour différentes valeurs de retard qui peuvent être choisis sélectivement sous la commande d'une mémoire respectivement par l'intermédiaire d'un circuit de commande multiplex (7, 8).

en ce qu'une sortie, caractérisant la voie I, du circuit de commande multiplex (7) est relié à une première porte ET (34), en ce qu'une sortie, caractérisant la voie II, du circuit de commande multiplex (8) est reliée à une seconde porte ET (35), en ce que les signaux définissant les intervalles entre impulsions sont appliqués alternativement, par l'intermédiaire d'un circuit basculant bistable (14), aux portes ET (34) et (35), en ce que la sortie de la première porte ET (34) est reliée à un compteur (45) pouvant être chargé par l'intermédiaire d'une mémoire (43) pour former le flanc montant d'un impulsion à produire par l'intermédiaire de la voie I, et avec un compteur (47) pouvant être chargé par l'intermédiaire d'une mémoire (44) pour former le flanc descendant de cette impulsion, et

en ce que la sortie de la porte ET (35) est reliée à un compteur (46) pouvant être chargé par l'intermédiaire de la mémoire (43) pour former le flanc montant d'une impulsion à produire par l'intermédiaire de la voie II et avec un compteur (48) pouvant être chargé par l'intermédiaire de la mémoire (44) pour former le flanc descendant de cette impulsion,

en ce que les sorties de ces compteurs (45 et 46 ou 47 et 48) prévus pour former les flancs montants ou les flancs descendants sont respectivement reliées avec un circuit de retardement commun (51 ou 52), chaque circuit comportant une série d'accès (62, 79) pour différentes valeurs de retard, qui peuvent être choisis sélectivement sous la commande d'une mémoire par l'intermédiaire d'un autre circuit de commande multiplex respectif (53 ou 54), et

en ce que les sorties des deux circuits de commande multiplex (53, 54) sont combinées (65).

9. Dispositif selon la revendication 8, caractérisé en ce que les compteurs (45, 46, 47, 48) sont des compteurs décroissants.

10. Dispositif selon la revendication 8, caractérisé en ce que les sorties (64, 66) des circuits de commande multiplex (53, 54) sont combinées par l'intermédiaire d'un circuit basculant bistable (55).

11. Dispositif selon la rendication 8, caractérisé en ce qu'il est prévu respectivement un circuit de retardement (24, 25) en amont des portes ET (34, 35).

12. Dispositif selon les revendications 8 et 11, caractérisé en ce qu'il est prévu respectivement en amont des portes ET (34, 35) un circuit basculant relié aux sorties des compteurs (45, 46, 47, 48).

**Claims**

1. Method for the generation without dead time of pulses (I1, I2, . . .; $I_A$, $I_B$, $I_C$) appearing in successive pulse intervals (IN1, IN2, . . .; IIN1, IIN2, . . .), with a high time resolution of the pulse intervals and of the pulses, characterized in

that via an oscillator (1) for giving coarse time raster values, and by delay circuits (3, 4 respectively) arranged in series with the oscillator (1) for fine time raster values and controlled as a function of stored time values, with selective (7, 8) delay circuits tabs (5, 6) signals characterizing start (IIN1A, IIN2A) and end (IIN1E, IIN2E) of a pulse interval are generated,

that the signals characterizing the pulse intervals are alternatingly applied to one respective of two paths (path I, path II) in such a manner that the signal characterizing the respective beginning of the pulse interval is in accordance with the time raster value given by the oscillator (1),

that for each path the leading and trailing edge of a pulse to be generated during a pulse interval is derived via counters (45, 46 and 47 respectively) driven by the clock of the oscillator (1) and loadable with a count from a storage (43 and 44 respectively) when a specific count is reached,

that for generating the leading and trailing edge a common delay circuit (51 and 52, respectively) with storage-controlled (43, 44), selectively addressable delay circuit tabs (62, 79, respectively) is arranged in series to the counters (45, 46 and 47, 48, respectively) for a fine time raster, and

that the pulse information generated alternatingly in accordance with both paths is joined on a common line (65).

2. Method as claimed in claim 1, characterized by its use for testing high speed storage products, or high speed logic circuits.

3. Method as claimed in any one of claims 1 to 2, characterized in that the pulses generated within the pulse intervals are used for keying equal or different frequencies.

4. Method as claimed in any one of claims 1 to 2, characterized in that the signals characterizing the start of the pulses or pulse intervals are used for generating a discrete frequency spectrum.

5. Method as claimed in any one of claims 1 to 2, characterized in that the stored values for the time relations of the pulse intervals and pulses are given by a program instruction.

6. Method as claimed in any one of claims 1, 2 or 5 characterized in that the pulse (IA) to be generated continues from one pulse interval (IIN1) into the next pulse interval (IIN2).

7. Method as claimed in any one of claims 1, 2 or 5, characterized in that during a pulse interval (IIN1; IIN2) the storage values are given for generating a pulse (IB; IC) which follows in the subsequent pulse interval (IIN2; IIN3).

8. Arrangement for carrying out the method as claimed in any one of claims 1 to 7, with an oscillator circuit (1), characterized in that the oscillator circuit (1) is connected to a first delay circuit (3) and to a second delay circuit (4),

that each of these delay circuits (3, 4) shows a number of taps (5, 6) for different delay values which are selectively addressable under storage control via one respective multiplex control circuit (7, 8),

that a multiplex control circuit (7) output characterizing path I is applicable to a first AND gate (34), and

that a multiplex control circuit (8) output characterizing path II is applicable to a second AND gate (35),

that the signals defining the pulse intervals are alternatingly applied via a flip-flop (14) to AND gates (34 and 35),

that the output of the first AND gate (34) is connected to a counter (45) re-loadable via a storage (43) for forming via path I the leading edge of a pulse to be generated, and to a counter (47) reloadable via a storage (44) for generating the trailing edge of this pulse, and

that the output of the AND gate (35) is connected to a counter (46) re-loadable via the storage (43) for forming via path II the leading edge of a pulse to be generated, and to a counter (48) re-loadable via storage (44) for generating the trailing edge of this pulse,

that the outputs of these counters (45 and 46, and 47 and 48, respectively) provided for generating the leading and trailing edges are each connected to a common delay circuit (51 and 52, respectively), each showing a number of taps (62 and 79, respectively) for different delay values which under storage control are respectively selectively addressable via a further multiplex control circuit (53 and 54, respectively), and that the outputs of both multiplex control circuits (53, 54) are joined (65).

9. Arrangement as claimed in claim 8, characterized in that the counters (45, 46, 47, 48) are down counters.

10. Arrangement as claimed in claim 8, characterized in that the outputs (64, 66) of the multiplex control circuits (53, 54) are joined via a flipflop (55).

11. Arrangement as claimed in claim 8, characterized in that the AND gates (34 and 35) are each preceded by a delay circuit (24, 25).

12. Arrangement as claimed in claims 8 and 11, characterized in that the AND gates (34 and 35) are each preceded by a flipflop connected to the outputs of the counters (45, 46, 47, 48).

FIG. 1

0 042 961

0 042 961

FIG. 2A

FIG. 2B

FIG. 2C

FIG. 2D

FIG. 3A

FIG. 3B

FIG. 3C

FIG. 4A

FIG. 4B

FIG. 4C

FIG. 5A

FIG. 5B

FIG. 5C

FIG. 5D

FIG. 5E

FIG. 6A

FIG. 6B